# FASCICULE DE BREVET EUROPEEN

(11) **EP 0 597 055 B1**
(45) Date de publication et mention de la délivrance du brevet: **17.12.1997**
(21) Numéro de dépôt: 93909742.4
(22) Date de dépôt: 24.05.1993
(51) Int. Cl.: G06K 19/077

(54) **ETIQUETTE ELECTRONIQUE**
Elektronisches Etikett
ELECTRONIC TAG

(30) Priorité: 25.05.1992 CH 1669/92
(43) Date de publication de la demande: 18.05.1994
(73) Titulaire: Gay Frères Vente et Exportation SA, 1211 Genève 3 (CH)
(72) Inventeur: BERNEY, Jean Claude, 1343 Les Charbonnierés (CH)
(74) Mandataire: Frei, Alexandra Sarah
(86) Numéro de dépôt international: CH9300133
(87) Numéro de publication internationale: WO9324902

(56) Documents cités:
- EP-A- 0 367 311
- DE-A- 3 235 650
- DE-A- 3 526 435
- FR-A- 2 336 741
- FR-A- 2 558 291
- GB-A- 2 082 804
- US-A- 4 004 133

## Description

Le domaine des étiquettes électroniques est actuellement en pleine expansion. Il s'agit en fait de systèmes comportant une mémoire électronique soit à lecture seule (ROM), soit à lecture-écriture (RAM, EPROM, EEPROM) où il est possible d'enregistrer et de lire des informations concernant le produit sur lequel l'étiquette est montée.

Certaines de ces étiquettes sont de dimensions relativement importantes, mais il y a une tendance réelle à la miniaturisation, de sorte que ces étiquettes puissent être logées de manière discrète dans toutes sortes de produits.

Par ailleurs, la tendance actuelle est de pouvoir lire l'étiquette à une certaine distance, ce qui implique l'incorporation d'une bobine pour la transmission de signaux sans contacts.

Bien que l'on soit arrivé déjà à des exécutions très miniaturisées, notamment des étiquettes électroniques implantables pour animaux, ou des versions extra-plates que l'on peut incorporer dans un format "carte de crédit" standard, cela est insuffisant pour certaines applications. Une étiquette électronique selon le préambule de la revendication 1 est divulguée par DE-A-3 526 435.

La présente invention concerne une étiquette électronique miniature où l'on a remplacé la bobine par un système d'accès direct par contacts. Cette étiquette électronique comportant un circuit intégré mémoire accessible électriquement par deux lignes d'interconnexion, est caractérisé par le fait qu'elle comporte une plaquette métallique servant de support, ladite plaquette étant reliée électriquement à la première ligne d'interconnexion, et comportant une ouverture par laquelle il est possible d'accéder à une zone de contact reliée, directement ou seulement lorsqu'une pression externe est appliquée au niveau de la zone de contact, à la seconde ligne d'interconnexion.
La figure 1 représente à titre d'exemple une première exécution générale d'une étiquette électronique selon l'invention en coupe et en vue de dessus,
la figure 2 représente à titre d'exemple quelques détails d'exécution, en coupe en vue de dessus et en deux détails agrandis,
les figures 3 et 4 représentent des exemples d'assemblage de l'étiquette et d'objets,
la figure 5 est une coupe d'une deuxième forme d'exécution et
la figure 6 est une vue de dessus de la deuxième forme d'exécution.

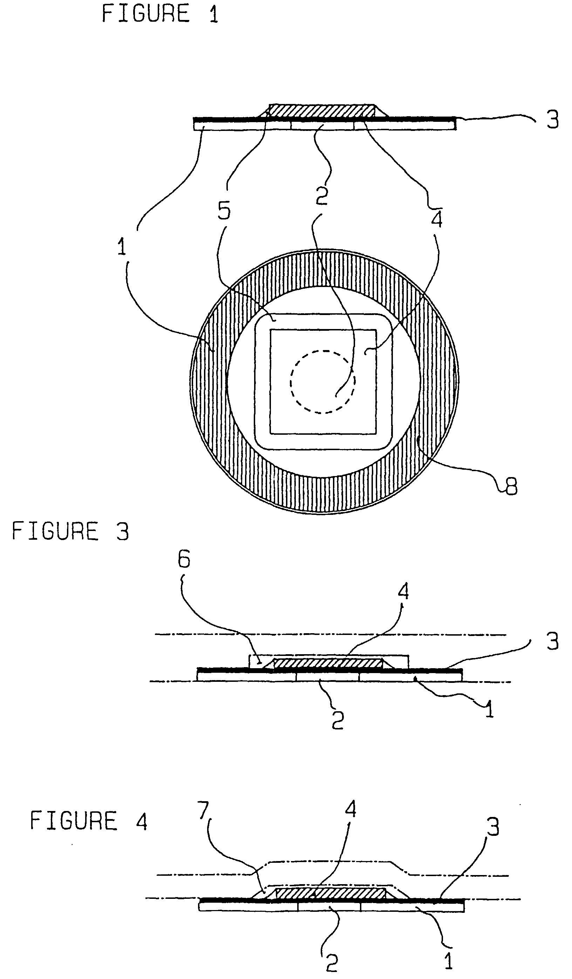

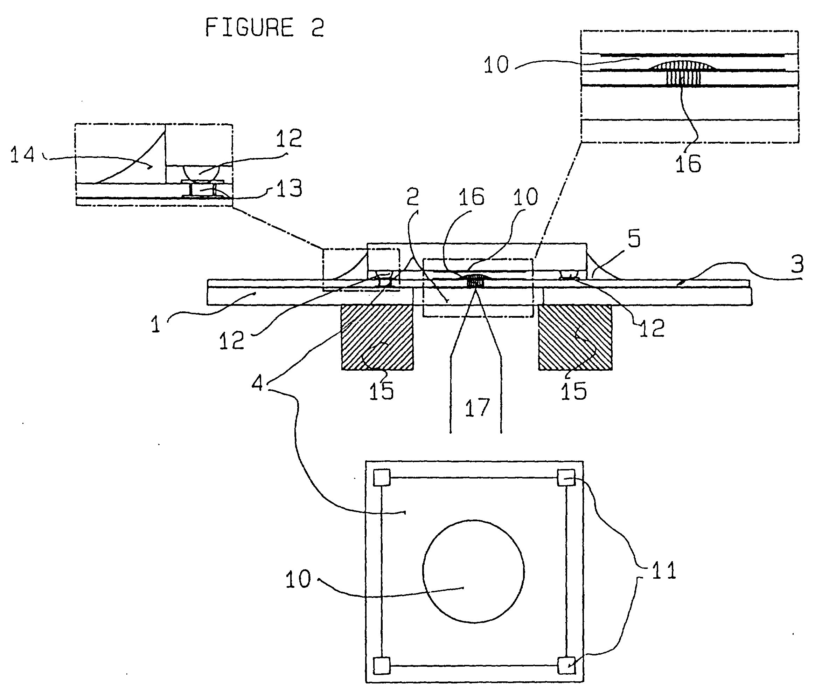

Sur la figure 1, on trouve la plaquette métallique 1 de forme circulaire, avec en son centre le trou 2. Une interface d'interconnexion mince 3 de type circuit imprimé est monté sur ladite plaquette. Et enfin un circuit intégré mémoire 4 est à son tour monté sur le circuit imprimé 3 et fixé par un filet de colle 5. Les interconnexions entre ces différents éléments sont données plus en détail à la figure 2.

L'étiquette électronique ainsi formée peut être montée dans un logement usiné 6 ou préformé 7 selon les figures 3 et 4, de tout objet à qui l'étiquette électronique est destiné. Cette étiquette se prête particulièrement bien à des applications sur objets métalliques où l'on peut garantir une certaine rigidité du logement. Par ailleurs, la plaquette métallique peut être réalisée dans le même métal que celui du logement dans lequel elle doit être fixée. Ainsi, si les logements 6 et 7 sont réalisés dans des objets en or, la plaquette 1 sera également en or. Cela a une importance; le choix, porte sur des matériaux nobles tel que l'or ou de la platine, en raison de réglements très stricts pour l'obtention des poinçons officiels. Par ailleurs, compte tenu des très faibles dimensions que l'on peut obtenir, comme exemple typique un diamètre de 5 mm pour une hauteur de 0,5 mm, cette étiquette est particulièrement discrète.

Pour monter l'étiquette électronique dans des logements 6, 7 selon les fig. 3 et 4, on peut prévoir, sur l'interface 3 une zone pré-encollée 8 permettant de fixer l'étiquette dans son logement par thermocollage.

La figure 2 donne des détails sur les possibilités d'interconnexion entre les différents éléments décrits à la figure 1. On reconnait la plaquette métallique 1 avec son trou central 2, l'interface d'interconnexion 3 et la plaquette de silicium 4 du circuit intégré mémoire.

Le circuit intégré 4 comporte deux lignes d'interconnexion, la première reliée à une zone métallisée centrale 10, et la seconde reliée à quatre zones métallisées périphériques. On peut ainsi dire que ces deux lignes sont coaxiales. Les quatre zones périphériques 11 comportent quatre bumps 12 venant en regard de zones métallisées du circuit imprimé 3 reliées galvaniquement à la plaquette métallique de base. Il est ainsi possible de fixer le circuit intégré 4 sur l'interface d'interconnexion 3 par thermocompression.

La plaquette métallique 1 est alors reliée galvaniquement à la première ligne d'interconnexion, et il est possible d'établir le contact avec cette première ligne d'interconnexion au moyen, par exemple, d'un contact circulaire 15 réalisé en caoutchouc conducteur, pressé contre la plaquette métallique.

Le cordon de colle 14, réalisé avec de la colle non conductrice, sert uniquement à assurer l'étanchéité et la solidité de l'assemblage.

Par ailleurs, l'interface d'interconnexion 3 comporte en son centre un élément de contact 16 venant en regard de la zone métallisé centrale du circuit intégré 10. En utilisant un interface de connexion 3 en Kapton, matériau présentant une certaine souplesse, il est possible d'établir le contact avec la zone métallisée 10, et par là avec la seconde ligne d'interconnexion, en introduisant un contact à ressort 17 dans le trou de la plaquette métallique 2.

En résumé, il est possible, au moyen du système de contacts coaxiaux 15, 17 montés dans une seconde sonde appropriée, d'accéder aux deux lignes de connexion du circuit integré.

D'autres formes d'exécution sont bien sûr possibles.

Par exemple, l'interface d'interconnexion 3 pourrait être supprimé, et le circuit intégré 4 monté directement par thermo-compression sur la plaquette 1. Dans ce cas, on pourrait accéder directement avec le contact 17 à la métallisation centrale 10. Cependant, le circuit intégré serait alors à l'air libre, ce qui n'est possible que dans des applications particulières.

Par ailleurs on sait que, dans la plupart des circuits intégrés, le substrat peut être relié à l'une des lignes d'interconnexion. De ce fait le contact entre cette ligne et la plaquette peut être obtenu directement en mettant un cordon 14 en colle conductrice, et en supprimant la liaison par les métallisations 11, les bumps 12 et les zones 13.

Les autres éléments de l'étiquette électronique selon l'invention, notamment ceux en rapport avec les caractéristiques de la mémoire proprement dit sont connus de l'homme du métier et ne sont donc pas décrits en détail.

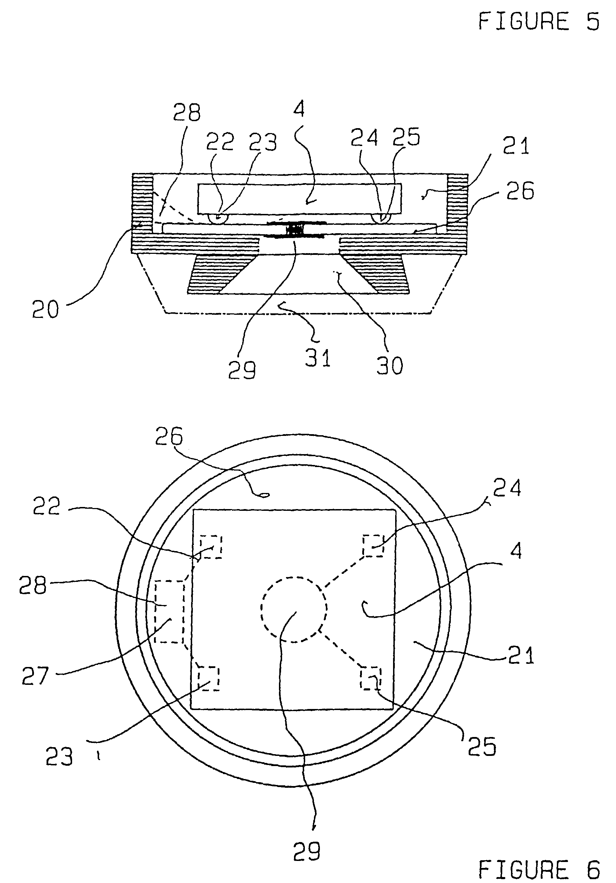

Les figures 5 et 6 montrent une autre forme d'exécution de l'étiquette selon l'invention. Dans ce cas la plaquette métallique 20 est une plaquette de forme obtenue par exemple par formage. Le bord de cette plaquette est replié à 90 degrés de manière à former un logement 21 dans lequel le circuit intégré 4 est monté d'une manière similaire à celle utilisée à la figure 2. Cependant le circuit intégré ne comporte pas de métallisation centrale mais quatre pads situés à sa périphérie, les deux premiers 22, 23 étant reliés à la première ligne d'interconnexion, et les deux derniers 24, 25 à la deuxième ligne d'interconnexion.

Les pads 22 et 23 sont soudés par thermocompression sur un circuit imprimé 26 et reliés à une zone de contact 27 de ce circuit imprimé. Cette zone de contact peut être reliée par une goutte de colle conductrice 28 à la paroi de la plaquette métallique 20 qui est donc reliée ainsi électriquement à la première ligne d'interconnexion.

Les pads 24 et 25, également soudés par thermocompression sur le circuit imprimé 26 sont reliés à une zone de contact centrale 29 du circuit imprimé. Cette zone de contact centrale se trouve sur les deux faces du circuit imprimé, ces deux faces étant reliées par exemple par un trou métallisé. Il est ainsi possible d'accéder avec une pointe à la partie inférieure de cette zone de contact 29 et de se relier électriquement à la deuxième ligne d'interconnexion.

Avec cette forme particulière de la plaquette métallique, il est possible de couler une résine dans le logement après montage du circuit imprimé. Cela permet d'obtenir un composant compact et parfaitement protégé.

Dans cet exemple, la forme en partie conique du trou 30 et la forme de la plaquette sont conçues pour permettre le guidage de la pointe de contact. Cette forme particulière permet également de fixer un capot 31 de protection du contact.

## Revendications

1. Etiquette électronique comportant un circuit intégré mémoire (4) accessible électriquement par deux lignes d'interconnexion, caractérisée par le fait qu'elle comporte une plaquette métallique (1; 20) servant de support, ladite plaquette étant reliée électriquement à la première ligne d'interconnexion (11; 23, 24), et comportant une ouverture (2; 30) par laquelle il est possible d'accéder à une zone de contact (16; 29) reliée, directement ou seulement lorsqu'une pression externe est appliquée au niveau de la zone de contact, à la seconde ligne d'interconnexion (10; 24, 25).

2. Etiquette électronique selon la revendication 1, caractérisée par le fait que ledit circuit intégré (4) est monté directement sur ladite plaquette métallique (2; 20).

3. Etiquette électronique selon la revendication 2, caractérisée par le fait que ledit circuit intégré (4) est monté sur ladite plaquette métallique (2; 20) par l'intermédiaire d'une interface d'interconnexion (3; 26).

4. Etiquette électronique selon la revendication 3, caractérisée par le fait que l'interface d'interconnexion (3) comporte des zones conductrices (10, 11) formant un contact intermédiaire avec ladite deuxième ligne d'interconnexion.

5. Etiquette électronique selon la revendication 3, caractérisée par le fait que les liaisons électriques entre le circuit intégré (4) et l'interface d'interconnexion (3) ont été établies par thermocompression entre des zones métallisées du circuit intégré et des zones métallisées correspondantes dudit interface par l'intermédiaire de "bumps" (12) préalablement déposés sur les zones métallisées dudit circuit intégré (4).

6. Etiquette électronique selon la revendication 1, caractérisée par le fait que ladite plaquette métallique (1) est reliée à ladite première ligne d'interconnexion par l'intermédiaire du substrat dudit circuit intégré.

7. Etiquette électronique selon la revendication 6, caractérisée par le fait que ladite liaison entre la plaquette métallique (1) et le substrat du circuit intégré (4) est établie au moyen de colle conductrice.

8. Etiquette électronique selon la revendication 1, caractérisée par le fait que ladite plaquette métallique (1) comporte une zone préencollée (8) permettant de fixer ladite étiquette dans un logement (6, 7) prévu à cet effet.

9. Etiquette électronique selon la revendication 1, caractérisée par le fait que ladite plaquette métallique (1) est réalisée dans le même métal que le logement dans lequel elle est fixée.

10. Etiquette électronique selon l'une des revendications 1 à 9, caractérisée en ce que ladite plaquette métallique (20) est d'une forme comportant un logement (21) pour ledit circuit intégré et ladite ouverture présente une surface de guidage (30) pour une sonde ou pointe de contact.

11. Etiquette électronique selon la revendication 10, caractérisée en ce que ladite surface de guidage présente une partie conique.

12. Etiquette électronique selon la revendication 10 ou 11, caractérisée en ce que ladite plaquette métallique présente une surface extérieure inclinée permettant le montage à cran d'un capot de protection (31).

13. Etiquette électronique selon l'une des revendications 10 à 12, caractérisée en ce que ledit circuit imprimé (4) est enrobé dans une résine dans ledit logement (21).

## Claims

1. Electronic label comprising an integrated memory circuit (4) which is electrically accessible via two connecting lines, characterized in that it comprises a metallic card (1; 20) which serves as a support, said card being electrically connected to the first connecting line (11; 23, 24), and comprising an aperture (2; 30) via which a contact zone (16; 29) can be accessed, which contact zone being connected directly or only under the effect of an external pressure against the region of the contact zone, to the second connecting line (10; 24, 25).

2. The electronic label of claim 1, characterized in that said integrated circuit (4) is mounted directly on said metallic card (2; 20).

3. The electronic label of claim 2, characterized by the fact that said integrated circuit (4) is mounted on said metallic card (2; 20) by means of an connecting interface (3; 26).

4. The electronic label of claim 3, characterized by the fact that the connecting interface (3) comprises conductive zones (10, 11) forming an intermediate contact with said second connecting line.

5. The electronic label of claim 3, characterized by the fact that the electric connections between the integrated circuit (4) and the connecting interface (3) are established by thermocompression between metallized zones of the integrated circuit and corresponding metallized zones of said interface by means of "bumps" (12) disposed beforehand over the metallized zones of the integrated circuit (4).

6. The electronic label of claim 1, characterized in that the said metallic card (1) is connected to said first connecting line by means of the substrate of said integrated circuit.

7. The electronic label of claim 6, characterized in that said connection between the metallic card (1) and the substrate of the integrated circuit (4) is established by means of conductive adhesive.

8. The electronic label of claim 1, characterized in that said metallic card (1) comprises a pre-adhered zone (8) enabling said label to be fixed in a housing (6, 7) provided to this end.

9. The electronic label of claim 1, characterized in that said metallic card (1) is made of the same metal as the housing in which it is affixed.

10. The electronic label of one of claims 1 to 9, characterized in that said metallic card (20) is of a type comprising a housing (21) for said integrated circuit and said aperture having a surface for guiding (30) a probe or contact point.

11. The electronic label of claim 10, characterized in that said guidance surface has a conical portion.

12. The electronic label of claim 10 or 11, characterized in that the said metallic card has an inclined outer surface allowing a protective cover (31) to be fitted with a catch.

13. The electronic label of one of claims 10 to 12, characterized in that said printed circuit (4) is coated in a resin in said housing (21).

## Patentansprüche

1. Elektronische Etikette mit einer integrierten Speicherschaltung (4) die elektrisch über zwei Anschlussleitungen zugänglich ist, dadurch gekennzeichnet, dass die Etikette eine metallische Platte (1; 20) aufweist die als Träger dient, dass die Platte elektrisch mit der ersten Anschlussleitung (11; 23, 24) kontaktiert ist und dass die Platte eine Öffnung (2; 30) aufweist, über welche Öffnung ein Zugang zu einer Kontaktzone (16; 29) erfolgt, welche Kontaktzone direkt oder nur unter Ausübung eines Drucks im Bereich der Kontaktzone mit der zweiten Anschlussleitung (10; 24, 25) kontaktiert ist.

2. Elektronische Etikette gemäss Anspruch 1, dadurch gekennzeichnet, dass die integrierte Schaltung (4) direkt auf der metallischen Platte (2; 20) montiert ist.

3. Elektronische Etikette gemäss Anspruch 2, dadurch gekennzeichnet, dass die integrierte Schaltung (4) mittels einer Schnittstelle (3; 26) auf der metallischen Platte (2; 20) montiert ist.

4. Elektronische Etikette gemäss Anspruch 3, dadurch gekennzeichnet, dass die Schnittstelle (3) leitfähige Bereiche (10, 11) aufweist, welche einen intermediären Kontakt mit der zweiten Anschlussleitung bilden.

5. Elektronische Etikette gemäss Anspruch 3, dadurch gekennzeichnet, dass elektrische Verbindungen zwischen der integrierten Schaltung (4) und der Schnittstelle (3) über Thermokompression metallischer Bereiche der integrierten Schaltung mit entsprechenden Bereichen der Schnittstelle erfolgen.

6. Elektronische Etikette gemäss Anspruch 1, dadurch gekennzeichnet, dass die metallische Platte (1) über das Substrat der integrierten Schaltung (4) mit der ersten Anschlussleitung verbunden ist.

7. Elektronische Etikette gemäss Anspruch 6, dadurch gekennzeichnet, dass die Verbindung zwischen der metallischen Platte (1) und der integrierten Schaltung (4) mittels Leitkleber erfolgt.

8. Elektronische Etikette gemäss Anspruch 1, dadurch gekennzeichnet, dass die metallische Platte (1) vorbereitete Klebebereiche (8) für eine Befestigung der Etikette in einem Gehäuse (6, 7) aufweist.

9. Elektronische Etikette gemäss Anspruch 1, dadurch gekennzeichnet, dass die metallische Platte (1) aus dem gleichen Metall gefertigt ist, wie ein Gehäuse in welchem sie befestigt ist.

10. Elektronische Etikette gemäss einem der Ansprüche 1 bis 9, dadurch gekennzeichnet, dass die metallische Platte (1) derart gestaltet ist, dass sie ein Gehäuse (21) für die integrierte Schaltung aufweist und dass die Öffnung eine Führungsfläche (30) für eine Sonde oder Kontaktierungsspitze aufweist.

11. Elektronische Etikette gemäss Anspruch 10, dadurch gekennzeichnet, dass die Führungsfläche einen konisch geformten Bereich aufweist.

12. Elektronische Etikette gemäss Anspruch 10 oder 11, dadurch gekennzeichnet, dass die metallische Platte (1) zum Befestigen eines Schutzdeckels (31) eine schräge äussere Fläche aufweist.

13. Elektronische Etikette gemäss einem der Ansprüche 10 bis 12, dadurch gekennzeichnet, dass die integrierte Schaltung (4) in Harz eingegossen im Gehäuse (21) ist.
